# EUROPEAN PATENT SPECIFICATION

(11) **EP 4 542 247 B1**
(45) Date of publication and mention of the grant of the patent: **04.03.2026**
(21) Application number: 23306810.5
(22) Date of filing: 16.10.2023
(51) Int. Cl.: G01R 31/40, G01R 31/70, G01R 31/42, G01R 1/20

(54) **PROCESS FOR MONITORING A DEGRADATION STATE OF AN ELECTRICAL INTERCONNECTION IN A POWER MODULE ASSEMBLY**
VERFAHREN ZUR ÜBERWACHUNG EINES DEGRADATIONSZUSTANDS EINER ELEKTRISCHEN VERSCHALTUNG IN EINER LEISTUNGSMODULBAUGRUPPE
PROCÉDÉ DE SURVEILLANCE D'UN ÉTAT DE DÉGRADATION D'UNE INTERCONNEXION ÉLECTRIQUE DANS UN ENSEMBLE DE MODULE DE PUISSANCE

(43) Date of publication of application: 23.04.2025
(73) Proprietor: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: DEGRENNE, Nicolas, 35708 RENNES CEDEX 7 (FR); Kesbia, Nasreddine, 35708 RENNES CEDEX 7 (FR)
(74) Representative: Plasseraud IP

(56) References cited:
- DE-A1- 102010 062 377
- US-A1- 2020 044 457

## Description

The invention relates to a process for monitoring a degradation state of an electrical interconnection in a power module assembly. It also relates to a power module assembly that is adapted for implementing such process.

### -- BACKGROUND OF THE INVENTION --

Power module assemblies are used for numerous applications such as power converters, power-supply sources for motors, for example traction motors, in particular motors for electrical vehicles, etc. They operate by switching high currents and high voltages according to time-controlled sequences. Most of these power module assemblies comprise each several half-bridge branches which are connected in parallel with each other between first and second supply terminals. This allows supplying high or very high electrical currents to a load that is connected to an output of the power module assembly. Within such configuration, each half-bridge branch comprises at least a first switch, a first electrical interconnection, a mid-point terminal, a first diode and a second electrical interconnection that are connected serially, with the mid-point terminal that is intermediate between the first switch and first electrical interconnection on the one hand and the first diode and second electrical interconnection on the other hand. Such half-bridge branch is usually provided as a separate one-piece electrical element, commonly known as a module. The mid-point terminals of all half-bridge branches are connected to a load-supply terminal of the power module assembly.

In addition, within each half-bridge branch, a connection orientation of the first diode is such that when the first switch of this half-bridge branch is turned on, the first diode of the same half-bridge branch transitions from conducting state to blocked state.

Practically, each switch or diode is most often a separate semiconductor die, which is electrically connected to other electrical components through interconnections which may be bonded wires, solders, sintered layers, copper tracks, etc. But ageing of these interconnections, in particular due to thermal or mechanical stresses, is an issue for the lifetime of the power module assembly. It is then important to detect degradation state of such interconnections for requesting maintenance of the power module assembly in suitable time, including replacement of those of the half-bridge branches that comprise degraded interconnections.

Furthermore, it is known that having a diode transitioning from conducting state to blocked state makes a transient current, called reverse recovery current, flow in a branch that contains the diode. This reverse recovery current flows through the diode from cathode to anode to reverse-polarize the diode junction and thus produce the blocked state of the diode.

DE 10 2010 062377 A1 relates to an inverter arrangement that comprises at least one half-bridge branch based on switching elements and at least one current sensor for determining a current in the half-bridge branch or a variable which characterizes this current.

US 2020/044457 A1 discloses a converter circuit that includes a rectifying section and a diagnosis device configured to diagnose an abnormality of the converter circuit.

Starting from this situation, one object of the present invention consists in allowing detection of degraded interconnections within a power module assembly, advantageously while the power module assembly is being used.

Another object of the invention consists in allowing such detection without dismounting the power module assembly for testing purpose.

Still another object of the invention consists in providing a diagnosis of degradation states relating to electrical interconnections internal to the power module assembly, advantageously in real-time during a useful operation thereof.

### -- SUMMARY OF THE INVENTION --

For meeting at least one of these objects or others, a first aspect of the present invention proposes a new process for monitoring a degradation state of an electrical interconnection in a power module assembly that has the above-mentioned configuration. Within each half-bridge branch, a connection orientation of the first diode is such that when the first switch of this half-bridge branch is turned on, a reverse recovery current that originates from the first diode transitioning from conducting state to blocked state flows through the second electrical interconnection and also at least partially through the first electrical interconnection.

According to the invention, the process comprises connecting at least one sensor to the power module assembly so that at least one detection signal delivered by the at least one sensor is sensitive to time-variations of a current that flows through the first electrical interconnection of one of the half-bridge branches of the power module assembly, called tested branch. Then, the process further comprises the following first step sequence:
- capturing the detection signal that appears subsequent to a turning-on of the first switch of the tested branch; and
- based on features of the captured detection signal, inferring information about a degradation state of the second electrical interconnection of the tested branch.

Hence, the invention process uses the reverse recovery current that occurs subsequent to a turning-on of the first switch, to reveal alterations in the state of the second electrical interconnection through signal detection at the first electrical connection.

Preferably, the sensor may be permanently included within the power module assembly, so that the monitoring process can be implemented continually or repeatedly during useful operation of the power module assembly. Alternatively, the sensor may be connected to the power module assembly only for a test time, for example during a maintenance which includes the invention process.

Generally for the invention, the first switch that is concerned with turning-on switching operation for implementing the invention process, and the first electrical interconnection that is concerned with connection of the sensor, may be a top-side switch close to that of the first and second supply terminals which has the highest electrical potential value. But alternatively, it may be a bottom-side switch close to that of both supply terminals which has the lowest electrical potential value.

When the second electrical interconnection of the tested branch is comprised of several wires which are connected in parallel with each other, the information about the degradation state may comprise a number of wires that are damaged among the wires of the second electrical interconnection of the tested branch. In such case, repeated executions of the invention process provide diagnosis about a progressive degradation before the operation of the power module assembly is impeded by breaking of all the wires of the second electrical interconnection.

Again generally for the invention, the features of the detection signal that are used for inferring the degradation state of the second electrical interconnection of the tested branch may comprise at least one among:
- at least one peak value of the detection signal being higher or not than a threshold in absolute values;
- a sign of a part of the detection signal; and
- a difference in shape between two detection signals that have been captured during respective executions of the first step sequence relating each to a same one of the half-bridge branches of the power module assembly used as tested branch.

In first implementations of the invention process, the at least one sensor may comprise two voltage sensors which are each connected in parallel with the first electrical interconnection of one of the half-bridge branches of the power module assembly, different from the half-bridge branch of the other voltage sensor. Such first implementations provide better separation between the detection signal features that relate to each second electrical interconnection.

In second implementations of the invention process, a first node is intermediate between the first switch and the first electrical interconnection within each of at least two half-bridge branches of the power module assembly. Then, the at least one sensor may comprise a voltage sensor which is connected between the respective first nodes of these two half-bridge branches. Such second implementations allow reducing the sensor number that is necessary for monitoring all the second electrical interconnections comprised in the power module assembly.

The first step sequence of the invention process may be advantageously combined with a second step sequence dedicated to monitoring the degradation state of the first electrical interconnection of the tested branch, using the same sensor for the first and second step sequences. Thus, the first and second electrical interconnections of a same one of the half-bridge branches can be both monitored, advantageously during useful operation of the power module assembly. To this end, the process may further comprise the following second step sequence:
- using the at least one sensor, capturing another detection signal that appears subsequent to a turning-off of the first switch of the tested branch; and
- based on features of this another captured detection signal, inferring information about a degradation state of the first electrical interconnection of the tested branch.

According to a possible configuration for the power module assembly that may be preferred for common-mode rejection requirements, the second supply terminal is a reference terminal or a ground terminal, and the following features may be further implemented additionally:
- the first switch and the first electrical interconnection of the tested branch may be serially connected between the mid-point terminal of this tested branch and the second supply terminal;
- the first electrical interconnection is connected between the first switch and the second supply terminal within the tested branch; and
- the at least one sensor comprises a voltage sensor connected in parallel with the first electrical interconnection.

Generally, the invention process may be implemented with a configuration for the power module assembly that is suitable for supplying positive and negative currents to the load. In such cases, each of the half-bridge branches of the power module assembly may further comprise a respective second switch which is connected in parallel with the first diode of this half-bridge branch, and may further comprise a respective second diode which is connected in parallel with the first switch of the same half-bridge branch. Then, each of the half-bridge branches may arranged so that its first and second switches are turned on and turned off simultaneously but oppositely during an operation of the power module assembly. Furthermore, respective conducting directions of each of the first and second switches and of the in-parallel corresponding first or second diode are opposite.

With such configuration for the power module assembly, the first step sequence may be performed twice for the tested branch, one time for a load current exiting from the power module assembly at the load-supply terminal and for inferring the information about the degradation state of one of the first and second interconnections of the tested branch, and another time for the load current returning to the power module assembly at the load-supply terminal and for inferring information about the degradation state of the other one of the first and second interconnections of the tested branch.

Generally for the invention, each first switch may be of Isolated-Grid Bipolar Transistor type or of MOSFET type. If any, each second switch may also be of Isolated-Grid Bipolar Transistor type or of MOSFET type.

A second aspect of the invention proposes a power module assembly, which comprises at least two half-bridge branches connected in parallel with each other between first and second supply terminals, in which:
- each half-bridge branch comprises a first switch, a first electrical interconnection, a mid-point terminal, a first diode and a second electrical interconnection that are connected serially, with the mid-point terminal intermediate between the first switch and first electrical interconnection on the one hand and the first diode and second electrical interconnection on the other hand;
- the mid-point terminals of all half-bridge branches are connected to a load-supply terminal of the power module assembly; and
- a connection orientation of the first diode within each half-bridge branch is such that when the first switch of this half-bridge branch is turned on, a reverse recovery current that originates from the first diode transitioning from conducting state to blocked state flows through the second electrical interconnection and also at least partially through the first electrical interconnection.

According to the invention, the power module assembly further comprises:
- means for controlling a turning-on of the first switch of one of the half-bridge branches of the power module assembly, called branch to be tested;
- at least one sensor connected so as to deliver at least one detection signal that is sensitive to time-variations of a current that flows through the first electrical interconnection of the branch to be tested subsequent to the turning-on of the first switch of this branch to be tested; and
- at least one signal processing unit that is connected for receiving the detection signal from the at least one sensor, and configured for inferring information about a degradation state of the second electrical interconnection of the branch to be tested based on features of the detection signal.

Such power module assembly is suitable for implementing a monitoring process that meets the first invention aspect. In addition, the power module assembly may further have the optional additional features that have been recited above in connection with the first invention aspect. In particular, it may be suitable for supplying positive and negative currents to the load, and further suitable for implementing the second step sequence.

### -- BRIEF DESCRIPTION OF THE DRAWINGS --

Figure 1 shows a minimum configuration for a power module assembly which is suitable for implementing the invention process.
Figure 2 is a time-diagram of detection signals captured when implementing the monitoring process of the invention, for a first possible sensor-connection mode.
Figure 3 corresponds to Figure 2 for a second possible sensor-connection mode.
Figure 4 shows another power module assembly configuration which is also suitable for implementing the invention process.
Figure 5 shows still another power module assembly configuration which is also suitable for implementing the invention process.
Figures 6a and 6b show two connecting configurations for each diode in parallel with a switch within the power module assembly configuration of Figure 5.

Same reference numbers which are indicated in different ones of these figures denote identical elements of elements with identical function.

### -- DETAILED DESCRIPTION OF THE INVENTION --

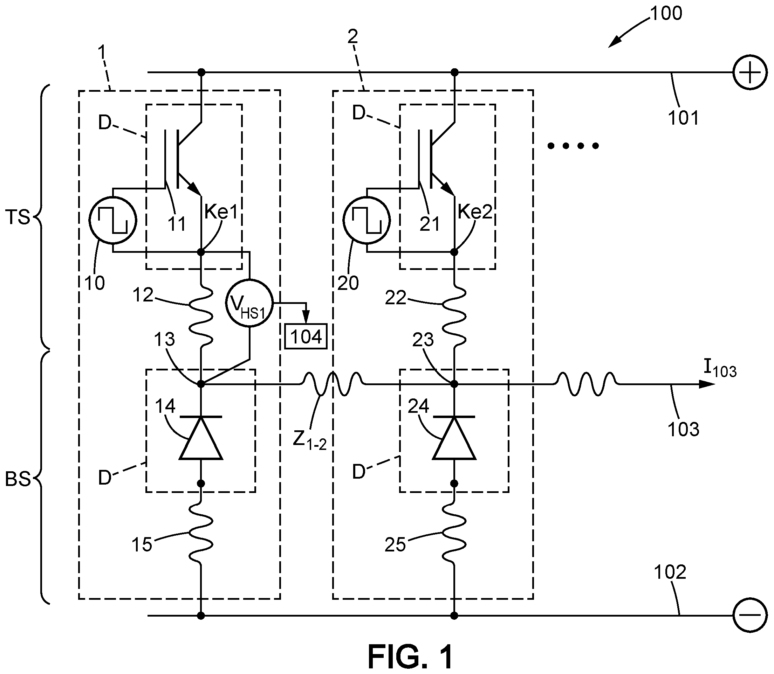

In Figure 1, reference number 100 denotes a power module assembly which comprises several half-bridge branches connected in parallel between a positive supply terminal 101 and a negative supply terminal 102. For clarity sake of the figure, only two half-bridge branches are shown, but their number may be any, for example up to ten. All the half-bridge branches may be similar, each comprising the following components connected in series in the following recitation order from the supply terminal 101 to the supply terminal 102, listed first for half-bridge branch 1:
a first switch 11, for example of MOSFET-type or IGBT-type, IGBT standing for Isolated-Grid Bipolar Transistor,
a first electrical interconnection 12,
a mid-point terminal 13,
a first diode 14, and
a second electrical interconnection 15.

With the same recitation order for half-bridge branch 2: first switch 21, first electrical interconnection 22, mid-point terminal 23, first diode 24 and second electrical interconnection 25.

The mid-point terminals 13, 23,... are all connected to a load-supply terminal 103 of the power module assembly 100, so that higher output current, called load current hereafter and noted I₁₀₃, can be supplied to a load (not represented) as an addition of respective load-current contributions of the half-bridge branches 1, 2... In Figure 1, reference sign Z₁₋₂ denotes an impedance of the interconnection between mid-point terminals 13 and 23.

The switches 11, 21... and diodes 14, 24... may each be produced as a separate die generally denoted as D, and the electrical interconnections 12, 22..., 15, 25... may each be produced as a bundle of bonded wires, for example bundles each of ten bonded wires. If the first switches 11 and 21 are IGBTs, the terminal of each switch 11 or 21 that is connected to the first electrical interconnection 12 or 22, respectively, is commonly known as Kelvin emitter. It is noted Ke1 (respectively Ke2) for switch 11 (resp. 21). The Kelvin emitters Ke1 and Ke2 have been called first nodes in the general part of the present description. Then, the mid-point terminals 13 and 23 are commonly known as power-emitters. The respective collectors of IGBT-type switches 11, 21 are connected to the positive supply terminal 101. The cathode of diode 14 (respectively 24) is connected to the mid-point terminal 13 (resp. 23), and the anode of diode 14 (resp. 24) is connected to the second electrical interconnection 15 (resp. 25), thus oriented opposite the conducting direction of the switch 11 (resp. 21).

For useful operation of the power module assembly 100, switch 11 may be controlled by a first control generator 10, switch 21 by a second control generator 20, and so on for each half-bridge branch, but a single common control generator may alternatively be used for controlling all switches 11, 21... The control generator 10 forms the means for controlling turning-on of the switch 11 as introduced in the general part of this description. The assembly part that is connected between the supply terminal 101 and the load-supply terminal 103 is commonly called top-side part, denoted TS, and the other assembly part that is connected between the load-supply terminal 103 and the supply terminal 102 is commonly called bottom-side part, denoted BS. Such structure for the power module assembly 100 is known and very much used for numerous power applications. Each half-bridge branch 1, 2... may be provided as a separate module, and it is an issue to monitor correct operation of each of these modules over long use times of the power module assembly 100. A first issue in this respect is detecting possible degradations in each one of the second electrical interconnections 15, 25... The invention process for addressing this first issue is explained now. An improvement of the invention may consist in detecting possible degradations also in each one of the first electrical interconnections 12, 22... and will be described later.

According to the invention process, a sensor is connected to be sensitive to the current flowing in the first electrical interconnection 12. Such sensor may be a high-speed voltmeter V_{HS1} connected according to one of the following connecting modes:
- between the Kelvin emitter Ke1 and the power-emitter 13 as shown in Figure 1; or
- between both Kelvin emitters Ke1 and Ke2, thus in parallel with the serially-combined interconnection 12, impedance Z₁₋₂ and interconnection 22.

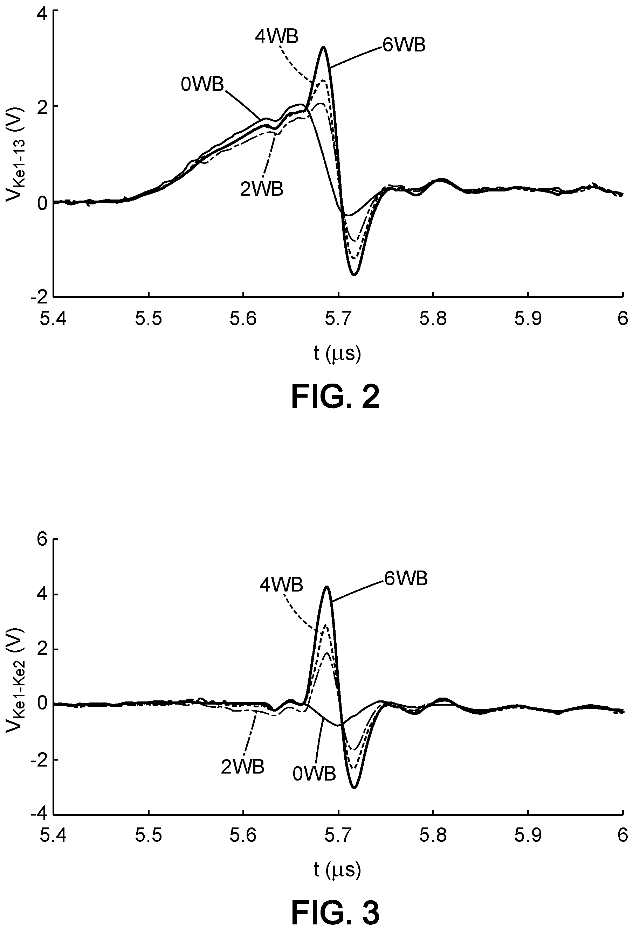

In both cases, plus-terminal of the high-speed voltmeter V_{HS1} may be connected to the Kelvin emitter Ke1. Voltage profile as sensed by the high-speed voltmeter V_{HS1} is then recorded during operation of the power module assembly 100, from a turning-on of the switch 11 as controlled by the control generator 10 and until a recordation end-time which is before the subsequent turning-off of the switch 11. The turning-on causes a current contribution to start flowing from the supply terminal 101 to the load-supply terminal 103. But in a known manner, the turning-on of the switch 11 causes an immediate transition of the diode 14 from conducting state to blocked state of this latter, and such transition produces a transient reverse recovery current through the diode 14. This reverse recovery current originates partially from the top-side part of the half-bridge branch 1, but also partially from the top-side part of the half-bridge branch 2. But due to the impedance Z₁₋₂ of the interconnection between the power-emitters 13 and 23, the reverse recovery current of the diode 14 mainly flows through the top-side part of the half-bridge branch 1, i.e. through the switch 11 and the first interconnection 12 from the supply terminal 101. The voltage sensed by the high-speed voltmeter V_{HS1} connected between both ends of the first interconnection 12 is thus sensitive to the reverse recovery current of diode 14. It may be advantageous to time-filter this detection signal sensed by the high-speed voltmeter V_{HS1} to isolate the contribution of the reverse recovery current from the increase of the contribution of the half-bridge branch 1 to the load current I₁₀₃. Indeed, the reverse recovery current produces a voltage-overshoot subsequent to the turning-on of the switch 11, which is superposed to another voltage contribution due to the increase of the load-current contribution. Possibly, the detection signal may be accumulated over multiple successive turning-on switching operations of the switch 11. Since the reverse recovery current of diode 14 flows through the second interconnection 15, the overshoot amplitude in the detection signal as sensed by the high-speed voltmeter V_{HS1} reflects the degradation state of this second interconnection 15. All signal processing and analysis steps applied to the detection signal as outputted by the high-speed voltmeter V_{HS1}, including optional accumulation, time-windowing, peak detection, peak amplitude value measurement, thresholding, sign analysis, etc, may be executed by a signal processing unit 104 which is connected for receiving the detection signal. The time-diagram of Figure 2 shows several sensed voltage profiles obtained in this way, respectively for none of the bonded wires broken in the second interconnection 15 (curve labelled 0WB), two of the bonded wires which are broken in the second interconnection 15 (curve labelled 2WB), four of its bonded wires broken (curve labelled 4WB), and six of its bonded wires broken (curve labelled 6WB). In this diagram, x-axis indicates time values in microseconds (µs), noted t, and y-axis indicates the sensed instant voltage values in volts (V), noted V_{Ke1-13}. The shapes of the profiles are determined by the resistance and inductance values of the respective impedances of the electrical interconnections 12 and 15, and also the operation temperatures of the switches 11 and 21, but the amplitude of each profile reflects the number of broken wires existing in the second electrical interconnection 15. The detection signal provided by the high-speed voltmeter V_{HS1}, possibly accumulated over several turning-on switching operations of the switch 11 and filtered, may be processed through peak detection and measurement of the peak amplitude. The value of the peak amplitude may be compared with pre-recorded values for determining the number of broken wires in the second interconnection 15. Alternatively, voltage profiles can be pre-recorded corresponding to varying values for the number of broken wires, and the detection signal sensed for monitoring purpose is identified to one of the pre-recorded voltage profiles using a best-match algorithm. The pre-recorded voltage profiles may be reference profiles provided by a manufacturer of the power module assembly 100, or voltage profiles recorded earlier in the lifetime of the power module assembly 100, for example during quality tests carried out just after manufacture when all the interconnections are deemed to be undamaged.

Figure 3 is another time-diagram obtained when the high-speed voltmeter V_{HS1} is alternatively connected between both Kelvin emitters Ke1 and Ke2, again with plus-terminal of the voltmeter connected to the Kelvin emitter Ke1. x-axis has the same meaning as before and y-axis indicates the values for the instant voltage sensed between both Kelvin emitters Ke1 and Ke2, noted V_{Ke1}-_{Ke2}. The voltage profiles that are obtained in this another way are different from the previous ones, but they reflect again the number of wires that are broken in the second electrical interconnection 15. Having the high-speed voltmeter V_{HS1} connected between both Kelvin emitters Ke1 and Ke2 also allows monitoring possible degradation in the bonded wires that constitute the second electrical interconnection 25 of the half-bridge branch 2, in addition to monitoring the second electrical interconnection 15 of the half-bridge branch 1. Sign-analysis performed on the main peak in the detection signal directly indicates whether the degradation relates to interconnection 15 in half-bridge branch 1 or interconnection 25 in half-bridge branch 2. Curve labels 0WB, 2WB, 4WB and 6WB in Figure 3 have the same meanings as in Figure 2.

Obviously, the voltage profiles 0WB, 2WB, 4WB and 6WB such as displayed in Figure 2 and Figure 3 are altered when some of the wires of each of the second electrical interconnections 15 and 25 are broken simultaneously. But the resulting profiles can be pre-recorded for each combination of numbers of broken wires relating each to one of the second electrical interconnections of the power module assembly 100. The sensed profiles obtained during the monitoring process are compared again with such pre-records. However, in particular situations where both interconnections 15 and 25 are degraded each in a same extent as the other one, it is possible that the sensed profiles are not affected.

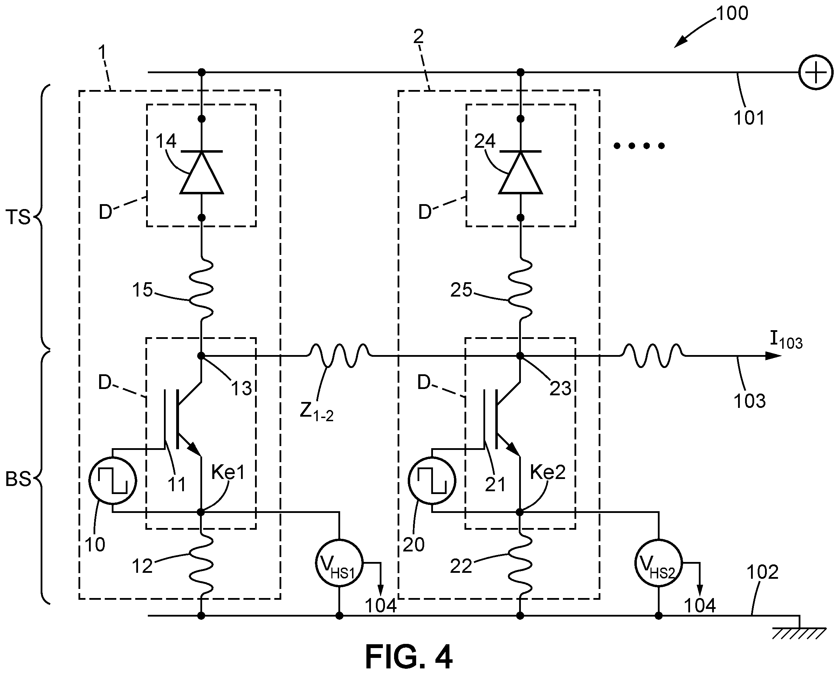

Figure 4 shows an alternative configuration for the power module assembly 100, which may be advantageous when implementing the invention process with a separate sensor dedicated to each half-bridge branch. In the power module assembly 100 of Figure 4, the components in the top-side part TS and bottom-side part BS have been swapped and the supply terminal 102 is grounded. The high-speed voltmeter V_{HS1} is dedicated again to the half-bridge branch 1, and is connected between the Kelvin emitter Ke1 in its new position at the bottom-side BS and the supply terminal 102, still in parallel with the first electrical interconnection 12. Similarly, a high-speed voltmeter V_{HS2} is dedicated to the half-bridge branch 2, connected between the Kelvin emitter Ke2 also at the bottom-side BS and the supply terminal 102. The plus-terminal of the high-speed voltmeter V_{HS1} (respectively V_{HS2}) is connected to the Kelvin emitter Ke1 (respectively Ke2), and the minus-terminal of each of the high-speed voltmeters V_{HS1} and V_{HS2} are connected to the grounded supply terminal 102. This has advantages for simplifying the design of the high-speed voltmeters V_{HS1} and V_{HS2}. Monitoring operation according to the invention is the same as described earlier: the detection signal sensed by the high-speed voltmeter V_{HS1} (resp. V_{HS2}) primarily reflects degradation possibly existing in the electrical interconnection 15 (resp. 25). To this end, both high-speed voltmeters V_{HS1} and V_{HS2} are connected for transmitting their respective detection signals to the signal processing unit 104.

It is also possible to further use the high-speed voltmeter(s) connected within a power module assembly 100 as described with reference to Figure 1 or Figure 4, for monitoring the degradation state of the first electrical interconnection 12, i.e. that one of the interconnections which belongs to the same top-side or bottom-side as the switch 11 which is currently controlled. This may be performed either by connecting the high-speed voltmeter V_{HS1} between the Kelvin emitter Ke1 and the power emitter 13 for the configuration of Figure 1, or between the Kelvin emitter Ke1 and the supply terminal 102 for the configuration of Figure 4. It may alternatively be performed by connecting the high-speed voltmeter V_{HS1} between both Kelvin emitters Ke1 and Ke2. Such monitoring of the first electrical interconnection 12 consists in recording the sensed voltage subsequent to a turning-off of the switch 11. This turning-off causes the current in the first electrical interconnection 12 to decrease, thereby producing a transient voltage in this first electrical interconnection 12 depending on its resistance and inductance values, and therefore reflecting the number of bonded wires of the first electrical interconnection 12 that are conducting or broken. This number can be inferred from the detection signal sensed by the high-speed voltmeter in a manner similar to that described above for the second electrical interconnection 15 using turning-on control of the switch 11. If the high-speed voltmeter has been connected between both Kelvin emitters Ke1 and Ke2, then the sign of the main peak in the sensed detection signal indicates that one of the first electrical interconnections 12 and 22 which is degraded. Again, voltage profiles may be pre-recorded which correspond to turning-off control of the switch 11 and to various numbers of broken wires in the first electrical interconnections 12 and 22, and the detection signal sensed by the high-speed voltmeter can be compared to these voltage profiles using a best-match algorithm. Complete interconnection monitoring, i.e. identification of the respective degradation states of the first and second interconnections 12 and 15 internal to the tested half-bridge branch 1 is thus possible using a single high-speed voltmeter.

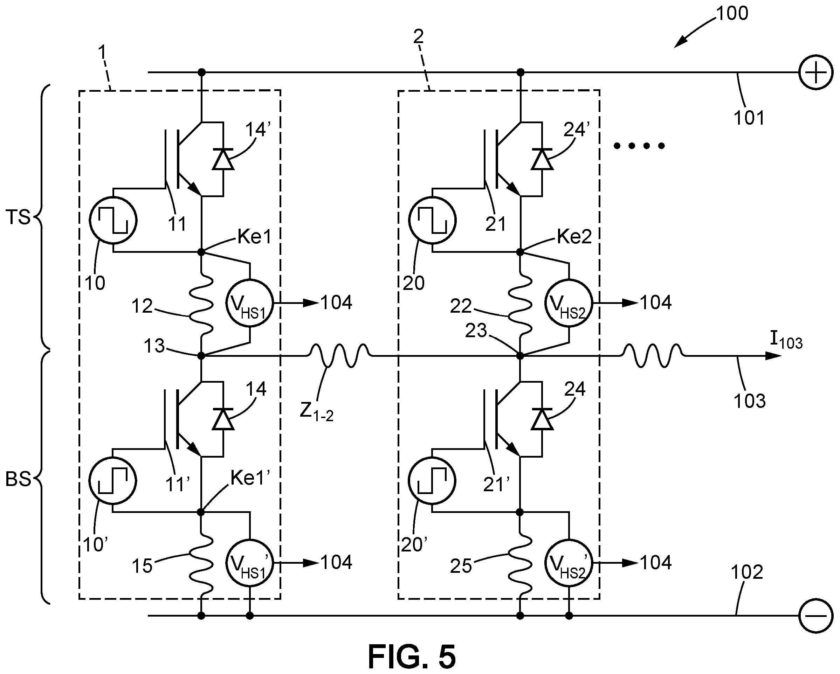

Figure 5 shows still another possible configuration for the power module assembly 100, in which the top-side TS and bottom-side BS of each half-bridge branch have similar structures. Thus, within the half-bridge branch 1, a second diode 14' is added in parallel with the switch 11, and a second switch 11' is added in parallel with the diode 14. The diode 14' is oriented anti-parallel with respect to the conducting direction of the switch 11, i.e. the cathode of the diode 14' is oriented toward the supply terminal 101. Similarly, the switch 11' is oriented anti-parallel with respect to the diode 14, i.e. the conducting direction of the switch 11' is oriented from the mid-point terminal 13 toward to the supply terminal 102. A second control generator 10' is also added for controlling the turning-on and turning-off switching operations of the switch 11'. For useful operation of such power module assembly 100, both control generators 10 and 10' are opposite in sign of the control signals so that the switch 11 turns on simultaneously with the switch 10' turning off, and vice-versa. Each other half-bridge branch of the power module assembly 100 has a structure similar to that of the half-bridge branch 1 just described. Thus, the half-bridge branch 2 is completed with another second switch 21', another second diode 24' and another control generator 20'. For implementing the invention monitoring process, the high-speed voltmeter V_{HS1} is connected again between the Kelvin emitter Ke1 and the power emitter 13 at the top-side TS. Then, for an operation time-period where positive load current I₁₀₃ exits from the power module assembly 100 through the load-supply terminal 103, detection signal sensed by the high-speed voltmeter V_{HS1} subsequent to a turning-on of the switch 11 controlled by the control generator 10 provides monitoring of the second electrical interconnection 15, and detection signal sensed by the voltmeter V_{HS1} too but subsequent to a turning-off of the switch 11 controlled by the control generator 10 provides monitoring of the first electrical interconnection 12.

In the configuration of Figure 5, it is possible adding a second high-speed voltmeter V_{HS1}' connected between the Kelvin emitter Ke1' and the supply terminal 102 at the bottom-side BS. Then, for an operation time-period where negative load current I₁₀₃ flows through the load-supply terminal 103, i.e. the load current enters into the power module assembly 100 from the load, the detection signal sensed by the high-speed voltmeter V_{HS1}' subsequent to a turning-on of the switch 11' controlled by the control generator 10' provides monitoring of the first electrical interconnection 12, and detection signal sensed by the voltmeter V_{HS1}' subsequent to a turning-off of the switch 11' controlled by the control generator 10' provides monitoring of the second electrical interconnection 15.

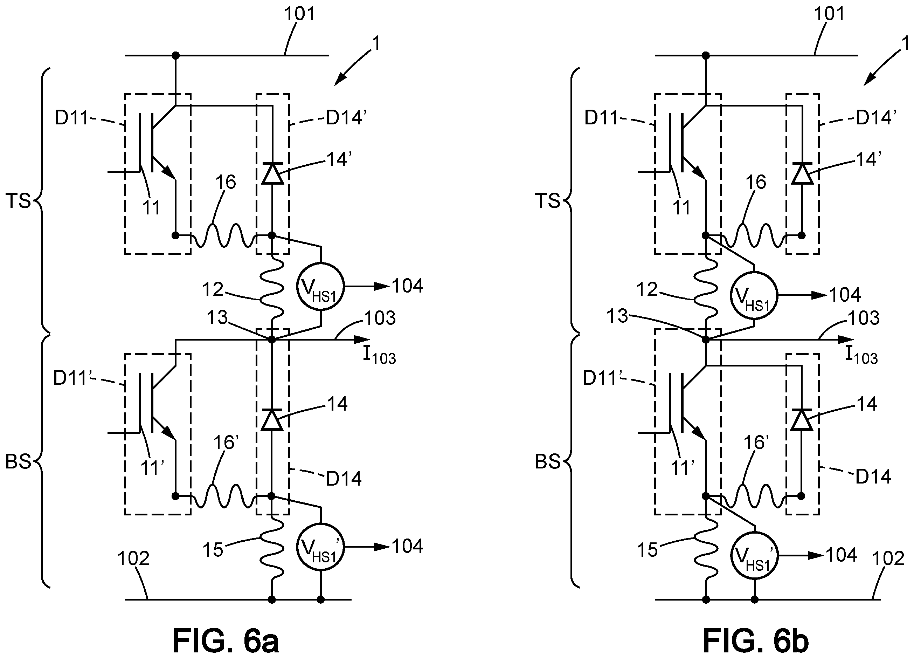

Actually, switch 11 and diode 14' connected as appearing in Figure 5 corresponds to both MOSFET and diode semiconductor components formed in a single die, and the same for switch 11' and diode 14 formed in another die. But most often switch 11 and diode 14' are formed as separate dice, and the same for switch 11' and diode 14. Then, each anti-parallel combination of a switch with the corresponding diode may have either the connection mode of Figure 6a or that of Figure 6b. In these figures, the respective dice of switches 11 and 11' are denoted D11 and D11', and those of diodes 14 and 14' denoted D14 and D14'. Due to separation between both dice D11 and D14' in the top-side TS on the one hand, and between dice D11' and D14 in the bottom-side BS on the other hand, the emitter of the switch 11 in top-side TS (respectively 11' in bottom-side BS) is connected to the anode of the diode 14' for top-side TS (resp. 14 for bottom-side BS) via an additional electrical interconnection 16 for top-side TS (16' for bottom-side BS). Then, the connection to the mid-point terminal 13 (resp. supply terminal 102) may originate either from between the additional electrical interconnection 16 (resp. 16') and the diode anode as shown in Figure 6a, or from between the switch emitter and the additional interconnection electrical 16 (resp. 16') as shown in Figure 6b. The following Table 1 gathers the degradation monitoring that provides the invention process, assuming that both top-side and bottom-side have either the connection configuration of Figure 6a or that of Figure 6b:

**Table 1**

| Switch used for control | Switching operation | I₁₀₃ | Sensing high-speed voltmeter | Monitored interconnection(s) in case of Fig. 6a | Monitored interconnection(s) in case of Fig. 6b |
|---|---|---|---|---|---|
| 11 top-side | Turning-on | positive | V_{HS1} | 15 only | 15 and 16' |
| 11 top-side | Turning-off | positive | V_{HS1} | 12 and 16 | 12 only |
| 11' bottom-side | Turning-on | negative | V_{HS1}' | 12 only | 12 and 16 |
| 11' bottom-side | Turning-off | negative | V_{HS1}' | 15 and 16' | 15 only |

For each connection mode of Figure 6a or Figure 6b, it is thus possible determining whether each one of the electrical interconnections 12, 16, 15 and 16' is degraded or not by combining the analyses of the detection signals provided by the high-speed voltmeters V_{HS1} and H_{vS1}' for the four testing conditions listed in Table 1. Similar monitoring is possible for the half-bridge branch 2 using the high-speed voltmeters V_{HS2} and V_{HS2}' connected as shown in Figure 5.

Although it has been indicated in the above description that the invention monitoring process can be implemented during useful operation of the power module assembly, thus considering that all the half-bridge branches are operated during execution of the monitoring process, it is possible alternatively to operate only the tested branch during the execution of the monitoring process. For example, when the tested branch is the half-bridge branch 1, the first step sequence or the second step sequence may be executed by controlling turning-on or -off switching operations of the control generator 10 or 10' while maintaining continually the control generators of all other half-bridge branches in off-state. This suppresses any possible mix-up when identifying damaged interconnections of separate half-bridge branches from the detection signals.

Finally, the invention monitoring process may be implemented with using a sensor of a type different than a voltmeter. For example, a current-meter can be used alternatively if connected serially instead of in-parallel with the electrical interconnection of concern.

## Claims

1. A process for monitoring a degradation state of an electrical interconnection in a power module assembly (100), said power module assembly comprising at least two half-bridge branches (1, 2) connected in parallel with each other between first and second supply terminals (101, 102),
each half-bridge branch (1, 2) comprising a first switch (11, 21), a first electrical interconnection (12, 22), a mid-point terminal (13, 23), a first diode (14, 24) and a second electrical interconnection (15, 25) that are connected serially, with the mid-point terminal intermediate between the first switch and the first electrical interconnection on the one hand and the first diode and the second electrical interconnection on the other hand,
the mid-point terminals (13, 23) of all half-bridge branches (1, 2) being connected to a load-supply terminal (103) of the power module assembly (100), wherein a connection orientation of the first diode (14, 24) within each half-bridge branch (1, 2) is such that when the first switch (11, 21) of said half-bridge branch is turned on, a reverse recovery current that originates from the first diode transitioning from conducting state to blocked state flows through the second electrical interconnection (15, 25) and also at least partially through the first electrical interconnection (12, 22),
the process comprising connecting at least one sensor to the power module assembly (100) so that at least one detection signal delivered by the at least one sensor is sensitive to time-variations of a current that flows through the first electrical interconnection (12) of one of the half-bridge branches (1, 2) of the power module assembly, called tested branch (1),
and the process is **characterised by** further comprising the following first step sequence:
- capturing the detection signal that appears subsequent to a turning-on of the first switch (11) of the tested branch (1); and
- based on features of the captured detection signal, inferring information about a degradation state of the second electrical interconnection (15) of said tested branch (1).

2. The process of claim 1, wherein the second electrical interconnection (15) of the tested branch (1) is comprised of several wires connected in parallel with each other, and the information about the degradation state of said second electrical interconnection of the tested branch comprises a number of wires that are damaged among the wires of said second electrical interconnection.

3. The process of claim 1 or 2, wherein the features of the detection signal that are used for inferring the degradation state of the second electrical interconnection (15) of the tested branch (1) comprise at least one among:
- at least one peak value of the detection signal being higher or not than a threshold in absolute values;
- a sign of a part of the detection signal; and
- a difference in shape between two detection signals that have been captured during respective executions of the first step sequence relating each to a same one of the half-bridge branches (1, 2) of the power module assembly (100) used as tested branch.

4. The process of one of claims 1 to 3, wherein the at least one sensor comprises two voltage sensors (V_{HS1}, V_{HS2}) which are each connected in parallel with the first electrical interconnection (12, 22) of one of the half-bridge branches (1, 2) of the power module assembly (100), different from the half-bridge branch of the other voltage sensor,
or a first node (Ke1, Ke2) is intermediate between the first switch (11, 21) and the first electrical interconnection (12, 22) within each of at least two half-bridge branches (1, 2) of the power module assembly (100), and the at least one sensor comprises a voltage sensor (V_{HS1}) which is connected between the respective first nodes of said two half-bridge branches.

5. The process of one of claims 1 to 4, further comprising the following second step sequence:
- using the at least one sensor, capturing another detection signal that appears subsequent to a turning-off of the first switch (11) of the tested branch (1); and
- based on features of said another captured detection signal, inferring information about a degradation state of the first electrical interconnection (12) of said tested branch (1).

6. The process of one of claims 1 to 5, wherein the second supply terminal (102) is a reference terminal or a ground terminal, and wherein:
- the first switch (11) and the first electrical interconnection (12) of the tested branch (1) are serially connected between the mid-point terminal (13) of said tested branch and the second supply terminal (102);
- the first electrical interconnection (12) is connected between the first switch (11) and the second supply terminal (102) within the tested branch (1); and
- the at least one sensor comprises a voltage sensor (V_{HS1}) connected in parallel with the first electrical interconnection (12).

7. The process of one of claims 1 to 6, wherein each of the half-bridge branches (1, 2) of the power module assembly (100) further comprises a respective second switch (11', 21') which is connected in parallel with the first diode (14, 24) of said half-bridge branch, and further comprises a respective second diode (14', 24') which is connected in parallel with the first switch (11, 21) of said half-bridge branch, and wherein each of the half-bridge branches is arranged so that the first and second switches of said half-bridge branch are turned on and turned off simultaneously but oppositely during an operation of the power module assembly, and respective conducting directions of each of said first and second switches and of the in-parallel corresponding first or second diode are opposite.

8. The process of claim 7, wherein the first step sequence is performed twice for the tested branch (1), one time for a load current (I₁₀₃) exiting from the power module assembly (100) at the load-supply terminal (103) and for inferring the information about the degradation state of one of the first (12) and second (15) interconnections of the tested branch (1), and another time for the load current returning to the power module assembly at the load-supply terminal and for inferring information about the degradation state of the other one of said first and second interconnections of the tested branch.

9. The process of claim 7 or 8, wherein each second switch (11', 21') is of Isolated-Grid Bipolar Transistor type or of MOSFET type.

10. The process of one of claims 1 to 9, wherein each first switch (11, 21) is of Isolated-Grid Bipolar Transistor type or of MOSFET type.

11. A power module assembly (100), comprising at least two half-bridge branches (1, 2) connected in parallel with each other between first and second supply terminals (101, 102),
each half-bridge branch (1, 2) comprising a first switch (11, 21), a first electrical interconnection (12, 22), a mid-point terminal (13, 23), a first diode (14, 24) and a second electrical interconnection (15, 25) that are connected serially, with the mid-point terminal intermediate between the first switch and the first electrical interconnection on the one hand and the first diode and the second electrical interconnection on the other hand,
the mid-point terminals (13, 23) of all half-bridge branches (1, 2) being connected to a load-supply terminal (103) of the power module assembly (100), wherein a connection orientation of the first diode (14, 24) within each half-bridge branch (1, 2) is such that when the first switch (11, 21) of said half-bridge branch is turned on, a reverse recovery current that originates from the first diode transitioning from conducting state to blocked state flows through the second electrical interconnection (15, 25) and also at least partially through the first electrical interconnection (12, 22),
wherein said power module assembly (100) further comprises:
- means (10) for controlling a turning-on of the first switch (11) of one of the half-bridge branches (1, 2) of the power module assembly (100), called branch to be tested (1); wherein the power module assembly is **characterised by**
- at least one sensor connected so as to deliver at least one detection signal that is sensitive to time-variations of a current that flows through the first electrical interconnection (12) of the branch to be tested (1) subsequent to the turning-on of the first switch (11) of said branch to be tested; and
- at least one signal processing unit (104) that is connected for receiving the detection signal from the at least one sensor, and configured for inferring information about a degradation state of the second electrical interconnection (15) of the branch to be tested (1) based on features of the detection signal.

## Patentansprüche

1. Verfahren zur Überwachung eines Degradationszustands einer elektrischen Verschaltung in einer Leistungsmodulbaugruppe (100), wobei die Leistungsmodulbaugruppe wenigstens zwei Halbbrückenäste (1, 2) umfasst, welche parallel zueinander zwischen einen ersten und einen zweiten Versorgungsanschluss (101, 102) geschaltet sind, wobei jeder Halbbrückenast (1, 2) einen ersten Schalter (11, 21), eine erste elektrische Verschaltung (12, 22), einen Mittelpunktanschluss (13, 23), eine erste Diode (14, 24) und eine zweite elektrische Verschaltung (15, 25) umfasst, welche in Reihe geschaltet sind, wobei der Mittelpunktanschluss zwischen dem ersten Schalter und der ersten elektrischen Verschaltung einerseits und der ersten Diode und der zweiten elektrischen Verschaltung andererseits liegt, wobei die Mittelpunktanschlüsse (13, 23) aller Halbbrückenäste (1, 2) mit einem Lastversorgungsanschluss (103) der Leistungsmodulbaugruppe (100) verbunden sind, wobei eine Verbindungsausrichtung der ersten Diode (14, 24) innerhalb jedes Halbbrückenasts (1, 2) derart ist, dass, wenn der erste Schalter (11, 21) des Halbbrückenasts eingeschaltet wird, ein Rückwärtserholungsstrom, welcher von der ersten Diode stammt, welche von einem leitenden Zustand in einen gesperrten Zustand übergeht, durch die zweite elektrische Verschaltung (15, 25) und auch wenigstens teilweise durch die erste elektrische Verschaltung (12, 22) fließt, wobei das Verfahren ein Verbinden wenigstens eines Sensors mit der Leistungsmodulbaugruppe (100) umfasst, so dass wenigstens ein Detektionssignal, welches von dem wenigstens einen Sensor geliefert wird, empfindlich gegenüber Zeitvariationen eines Stroms ist, welcher durch die erste elektrische Verschaltung (12) eines der Halbbrückenäste (1, 2) der Leistungsmodulbaugruppe fließt, welcher als getesteter Ast (1) bezeichnet wird, und wobei das Verfahren **dadurch gekennzeichnet ist, dass** es ferner die folgende erste Schrittsequenz umfasst:
- Erfassen des Detektionssignals, welches nach einem Einschalten des ersten Schalters (11) des getesteten Asts (1) auftritt; und
- Ableiten von Informationen über einen Degradationszustand der zweiten elektrischen Verschaltung (15) des getesteten Asts (1) auf Grundlage von Merkmalen des erfassten Detektionssignals.

2. Verfahren nach Anspruch 1, wobei die zweite elektrische Verschaltung (15) des getesteten Asts (1) aus mehreren Leitungen umfasst ist, welche parallel zueinander geschaltet sind, und die Informationen über den Degradationszustand der zweiten elektrischen Verschaltung des getesteten Asts eine Anzahl von Leitungen umfassen, welche unter den Leitungen der zweiten elektrischen Verschaltung beschädigt sind.

3. Verfahren nach Anspruch 1 oder 2, wobei die Merkmale des Detektionssignals, welche zum Ableiten des Degradationszustands der zweiten elektrischen Verschaltung (15) des getesteten Asts (1) verwendet werden, wenigstens eines umfassen aus:
- wenigstens einem Spitzenwert des Detektionssignals, welcher in absoluten Werten höher oder nicht höher als ein Schwellenwert ist;
- einem Vorzeichen eines Teils des Detektionssignals; und
- einem Unterschied in einer Form zwischen zwei Detektionssignalen, welche während jeweiliger Ausführungen der ersten Schrittsequenz erfasst worden sind, welche sich jeweils auf einen gleichen der Halbbrückenäste (1, 2) der Leistungsmodulbaugruppe (100) beziehen, welcher als getesteter Ast verwendet wird.

4. Verfahren nach einem der Ansprüche 1 bis 3, wobei der wenigstens eine Sensor zwei Spannungssensoren (V_{HS1}, V_{HS2}) umfasst, welche jeweils parallel mit der ersten elektrischen Verschaltung (12, 22) eines der Halbbrückenäste (1, 2) der Leistungsmodulbaugruppe (100) verbunden sind, welche sich von dem Halbbrückenast des anderen Spannungssensors unterscheiden,
oder wobei ein erster Knoten (Ke1, Ke2) zwischen dem ersten Schalter (11, 21) und der ersten elektrischen Verschaltung (12, 22) innerhalb jedes der wenigstens zwei Halbbrückenäste (1, 2) der Leistungsmodulbaugruppe (100) liegt, und der wenigstens eine Sensor einen Spannungssensor (V_{HS1}) umfasst, welcher zwischen den jeweiligen ersten Knoten der beiden Halbbrückenäste verbunden ist.

5. Verfahren nach einem der Ansprüche 1 bis 4, ferner umfassend die folgende zweite Schrittsequenz:
- unter Verwendung des wenigstens einen Sensors, Erfassen eines weiteren Detektionssignals, welches nach einem Abschalten des ersten Schalters (11) des getesteten Asts (1) auftritt; und
- Ableiten von Informationen über einen Degradationszustand der ersten elektrischen Verschaltung (12) des getesteten Asts (1) auf Grundlage von Merkmalen des weiteren erfassten Detektionssignals.

6. Verfahren nach einem der Ansprüche 1 bis 5, wobei der zweite Versorgungsanschluss (102) ein Referenzanschluss oder ein Erdungsanschluss ist, und wobei:
- der erste Schalter (11) und die erste elektrische Verschaltung (12) des getesteten Asts (1) zwischen dem Mittelpunktanschluss (13) des getesteten Asts und dem zweiten Versorgungsanschluss (102) in Reihe geschaltet sind;
- die erste elektrische Verschaltung (12) zwischen dem ersten Schalter (11) und dem zweiten Versorgungsanschluss (102) innerhalb des getesteten Asts (1) verbunden ist; und
- der wenigstens eine Sensor einen Spannungssensor (V_{HS1}) umfasst, welcher parallel zu der ersten elektrischen Verschaltung (12) geschaltet ist.

7. Verfahren nach einem der Ansprüche 1 bis 6, wobei jeder der Halbbrückenäste (1, 2) der Leistungsmodulbaugruppe (100) ferner einen jeweiligen zweiten Schalter (11', 21') umfasst, welcher parallel zu der ersten Diode (14, 24) des Halbbrückenasts geschaltet ist, und ferner eine jeweilige zweite Diode (14', 24') umfasst, welche parallel zu dem ersten Schalter (11, 21) des Halbbrückenasts geschaltet ist, und wobei jeder der Halbrückenäste so angeordnet ist, dass der erste und der zweite Schalter des Halbrückenasts während eines Betriebs der Leistungsmodulbaugruppe gleichzeitig, aber entgegengesetzt ein- und ausgeschaltet werden, und jeweilige Leitungsrichtungen jedes des ersten und des zweiten Schalters und der parallel dazu geschalteten entsprechenden ersten oder zweiten Diode entgegengesetzt sind.

8. Verfahren nach Anspruch 7, wobei die erste Schrittsequenz zweimal für den getesteten Ast (1) durchgeführt wird, einmal für einen Laststrom (I103), welcher aus der Leistungsmodulbaugruppe (100) an dem Lastversorgungsanschluss (103) abfließt, und zum Ableiten der Informationen über den Degradationszustand einer der ersten (12) und der zweiten (15) Verschaltungen des getesteten Asts (1), und ein weiteres Mal für den Laststrom, welcher zu der Leistungsmodulbaugruppe an dem Lastversorgungsanschluss zurückfließt und zum Ableiten der Informationen über den Degradationszustand der anderen aus der ersten und der zweiten Verschaltung des getesteten Asts.

9. Verfahren nach Anspruch 7 oder 8, wobei jeder zweite Schalter (11', 21') vom Typ eines isolierten Gitter-Bipolartransistors oder vom MOSFET-Typ ist.

10. Verfahren nach einem der Ansprüche 1 bis 9, wobei jeder erste Schalter (11, 21) vom Typ eines isolierten Gitter-Bipolartransistors oder vom MOSFET-Typ ist.

11. Leistungsmodulbaugruppe (100), umfassend wenigstens zwei Halbbrückenäste (1, 2), welche parallel zueinander zwischen einen ersten und einen zweiten Versorgungsanschluss (101, 102) geschaltet sind,
wobei jeder Halbbrückenast (1, 2) einen ersten Schalter (11, 21), eine erste elektrische Verschaltung (12, 22), einen Mittelpunktanschluss (13, 23), eine erste Diode (14, 24) und eine zweite elektrische Verschaltung (15, 25) umfasst, welche in Reihe geschaltet sind, wobei der Mittelpunktanschluss zwischen dem ersten Schalter und der ersten elektrischen Verschaltung einerseits und der ersten Diode und der zweiten elektrischen Verschaltung andererseits liegt,
wobei die Mittelpunktanschlüsse (13, 23) aller Halbbrückenäste (1, 2) mit einem Lastversorgungsanschluss (103) der Leistungsmodulbaugruppe (100) verbunden sind, wobei eine Verbindungsausrichtung der ersten Diode (14, 24) innerhalb jedes Halbbrückenasts (1, 2) derart ist, dass, wenn der erste Schalter (11, 21) des Halbbrückenasts eingeschaltet wird, ein Rückwärtserholungsstrom, welcher von der ersten Diode stammt, welche von einem leitenden Zustand in einen gesperrten Zustand übergeht, durch die zweite elektrische Verschaltung (15, 25) und auch wenigstens teilweise durch die erste elektrische Verschaltung (12, 22) fließt,
wobei die Leistungsmodulbaugruppe (100) ferner umfasst:
- Mittel (10) zum Steuern eines Einschaltens des ersten Schalters (11) eines der Halbbrückenäste (1, 2) der Leistungsmodulbaugruppe (100), welcher als zu testender Ast (1) bezeichnet wird; wobei die Leistungsmodulbaugruppe **dadurch gekennzeichnet ist, dass**
- wenigstens ein Sensor derart verbunden ist, dass er wenigstens ein Detektionssignal liefert, welches empfindlich gegenüber Zeitvariationen eines Stroms ist, welcher durch die erste elektrische Verschaltung (12) des zu testenden Asts (1) nach dem Einschalten des ersten Schalters (11) des zu testenden Asts fließt; und
- wenigstens eine Signalverarbeitungseinheit (104), welche zum Empfangen des Detektionssignals von dem wenigstens einen Sensor verbunden ist und zum Ableiten von Informationen über einen Degradationszustand der zweiten elektrischen Verschaltung (15) des zu testenden Asts (1) auf Grundlage von Merkmalen des Detektionssignals eingerichtet ist.

## Revendications

1. Procédé de surveillance d'un état de dégradation d'une interconnexion électrique dans un ensemble de module d'alimentation (100), ledit ensemble de module d'alimentation comprenant au moins deux branches de demi-pont (1, 2) connectées en parallèle l'une avec l'autre entre des première et seconde bornes d'alimentation (101, 102),
chaque branche de demi-pont (1, 2) comprenant un premier commutateur (11, 21), une première interconnexion électrique (12, 22), une borne de point médian (13, 23), une première diode (14, 24) et une seconde interconnexion électrique (15, 25) qui sont connectés en série, avec la borne de point médian intermédiaire entre le premier commutateur et la première interconnexion électrique d'une part et la première diode et la seconde interconnexion électrique d'autre part,
les bornes de point médian (13, 23) de toutes les branches de demi-pont (1, 2) étant connectées à une borne d'alimentation de charge (103) de l'ensemble de module d'alimentation (100),
dans lequel une orientation de connexion de la première diode (14, 24) au sein de chaque branche de demi-pont (1, 2) est telle que, lorsque le premier commutateur (11, 21) de ladite branche de demi-pont est activé, un courant de récupération inverse qui provient de la première diode passant de l'état conducteur à l'état bloqué circule à travers la seconde interconnexion électrique (15, 25) et également au moins partiellement à travers la première interconnexion électrique (12, 22),
le procédé comprenant la connexion d'au moins un capteur à l'ensemble de module d'alimentation (100) de sorte qu'au moins un signal de détection délivré par l'au moins un capteur soit sensible à des variations temporelles d'un courant qui circule à travers la première interconnexion électrique (12) d'une des branches de demi-pont (1, 2) de l'ensemble de module d'alimentation, appelée branche testée (1),
et le procédé est **caractérisé en ce qu'**il comprend en outre la première séquence d'étapes suivante :
- la saisie du signal de détection qui apparaît suite à une activation du premier commutateur (11) de la branche testée (1) ; et
- sur la base de caractéristiques du signal de détection saisi, la déduction d'informations sur un état de dégradation de la seconde interconnexion électrique (15) de ladite branche testée (1).

2. Procédé selon la revendication 1, dans lequel la seconde interconnexion électrique (15) de la branche testée (1) est composée de plusieurs fils connectés en parallèle les uns avec les autres, et les informations sur l'état de dégradation de ladite seconde interconnexion électrique de la branche testée comprennent un nombre de fils qui sont endommagés parmi les fils de ladite seconde interconnexion électrique.

3. Procédé selon la revendication 1 ou 2, dans lequel les caractéristiques du signal de détection qui sont utilisées pour déduire l'état de dégradation de la seconde interconnexion électrique (15) de la branche testée (1) comprennent au moins un élément parmi :
- au moins une valeur de pic du signal de détection qui est supérieure ou non à un seuil en valeurs absolues ;
- un signe d'une partie du signal de détection ; et
- une différence de forme entre deux signaux de détection qui ont été saisis lors d'exécutions respectives de la première séquence d'étapes relatives chacune à une même branche parmi les branches de demi-pont (1, 2) de l'ensemble de module d'alimentation (100) utilisée comme branche testée.

4. Procédé selon l'une des revendications 1 à 3, dans lequel le ou les capteurs comprennent deux capteurs de tension (V_{HS1}, V_{HS2}) qui sont chacun connectés en parallèle avec la première interconnexion électrique (12, 22) de l'une des branches de demi-pont (1, 2) de l'ensemble de module d'alimentation (100), différente de la branche de demi-pont de l'autre capteur de tension,
ou un premier nœud (Ke1, Ke2) est intermédiaire entre le premier commutateur (11, 21) et la première interconnexion électrique (12, 22) au sein de chacune d'au moins deux branches de demi-pont (1, 2) de l'ensemble de module d'alimentation (100), et le ou les capteurs comprennent un capteur de tension (V_{HS1}) qui est connecté entre les premiers nœuds respectifs desdites deux branches de demi-pont.

5. Procédé selon l'une des revendications 1 à 4, comprenant en outre la seconde séquence d'étapes suivante :
- à l'aide de l'au moins un capteur, la saisie d'un autre signal de détection qui apparaît suite à une désactivation du premier commutateur (11) de la branche testée (1) ; et
- sur la base de caractéristiques dudit autre signal de détection saisi, la déduction d'informations sur un état de dégradation de la première interconnexion électrique (12) de ladite branche testée (1).

6. Procédé selon l'une des revendications 1 à 5, dans lequel la seconde borne d'alimentation (102) est une borne de référence ou une borne de masse, et dans lequel :
- le premier commutateur (11) et la première interconnexion électrique (12) de la branche testée (1) sont connectés en série entre la borne de point médian (13) de ladite branche testée et la seconde borne d'alimentation (102) ;
- la première interconnexion électrique (12) est connectée entre le premier commutateur (11) et la seconde borne d'alimentation (102) au sein de la branche testée (1) ; et
- le ou les capteurs comprennent un capteur de tension (V_{HS1}) connecté en parallèle avec la première interconnexion électrique (12).

7. Procédé selon l'une des revendications 1 à 6, dans lequel chacune des branches de demi-pont (1, 2) de l'ensemble de module d'alimentation (100) comprend en outre un second commutateur (11', 21') respectif qui est connecté en parallèle avec la première diode (14, 24) de ladite branche de demi-pont, et comprend en outre une seconde diode (14', 24') respective qui est connectée en parallèle avec le premier commutateur (11, 21) de ladite branche de demi-pont, et dans lequel chacune des branches de demi-pont est agencée de sorte que les premier et second commutateurs de ladite branche de demi-pont sont activés et désactivés simultanément mais de manière opposée pendant un fonctionnement de l'ensemble de module d'alimentation, et des directions de conduction respectives de chacun desdits premier et second commutateurs et de la première ou seconde diode correspondante en parallèle sont opposées.

8. Procédé selon la revendication 7, dans lequel la première séquence d'étapes est exécutée deux fois pour la branche testée (1), une fois pour un courant de charge (I₁₀₃) sortant de l'ensemble de module d'alimentation (100) au niveau de la borne d'alimentation de charge (103) et pour déduire les informations sur l'état de dégradation de l'une des premières (12) et seconde (15) interconnexions de la branche testée (1), et une autre fois pour le courant de charge revenant à l'ensemble de module d'alimentation au niveau de la borne d'alimentation de charge et pour déduire des informations sur l'état de dégradation de l'autre desdites première et seconde interconnexions de la branche testée.

9. Procédé selon la revendication 7 ou 8, dans lequel chaque second commutateur (11', 21') est de type transistor bipolaire à grille isolée ou de type MOSFET.

10. Procédé selon l'une des revendications 1 à 9, dans lequel chaque premier commutateur (11, 21) est de type transistor bipolaire à grille isolée ou de type MOSFET.

11. Ensemble de module d'alimentation (100), comprenant au moins deux branches de demi-pont (1, 2) connectées en parallèle l'une avec l'autre entre des première et seconde bornes d'alimentation (101, 102),
chaque branche de demi-pont (1, 2) comprenant un premier commutateur (11, 21), une première interconnexion électrique (12, 22), une borne de point médian (13, 23), une première diode (14, 24) et une seconde interconnexion électrique (15, 25) qui sont connectés en série, avec la borne de point médian intermédiaire entre le premier commutateur et la première interconnexion électrique d'une part et la première diode et la seconde interconnexion électrique d'autre part,
les bornes de point médian (13, 23) de toutes les branches de demi-pont (1, 2) étant connectées à une borne d'alimentation de charge (103) de l'ensemble de module d'alimentation (100), dans lequel une orientation de connexion de la première diode (14, 24) au sein de chaque branche de demi-pont (1, 2) est telle que, lorsque le premier commutateur (11, 21) de ladite branche de demi-pont est activé, un courant de récupération inverse qui provient de la première diode passant de l'état conducteur à l'état bloqué circule à travers la seconde interconnexion électrique (15, 25) et également au moins partiellement à travers la première interconnexion électrique (12, 22),
dans lequel ledit ensemble de module d'alimentation (100) comprend en outre :
- des moyens (10) de commande d'une activation du premier commutateur (11) d'une des branches de demi-pont (1, 2) de l'ensemble de module d'alimentation (100), appelée branche à tester (1) ;
dans lequel l'ensemble de module d'alimentation est **caractérisé par**
- au moins un capteur connecté de manière à délivrer au moins un signal de détection sensible à des variations temporelles d'un courant qui circule à travers la première interconnexion électrique (12) de la branche à tester (1) suite à l'activation du premier commutateur (11) de ladite branche à tester ; et
- au moins une unité de traitement de signal (104) qui est connectée pour recevoir le signal de détection de l'au moins un capteur, et configurée pour déduire des informations sur un état de dégradation de la seconde interconnexion électrique (15) de la branche à tester (1) sur la base de caractéristiques du signal de détection.
